# DEMANDE DE BREVET EUROPEEN

(11) **EP 4 293 730 A1**
(43) Date de publication de la demande: **20.12.2023**
(21) Numéro de dépôt: 23178832.4
(22) Date de dépôt: 13.06.2023
(51) Int. Cl.: H01L 31/05, H01L 31/18

(54) **ÉLÉMENT D'INTERCONNEXION, CHAÎNE PHOTOVOLTAÏQUE ET PROCÉDÉS ASSOCIÉS**

(30) Priorité: 14.06.2022 FR 2205766
(71) Demandeur: Commissariat à l'énergie atomique et aux énergies alternatives, 75015 Paris (FR); Mondragon Assembly S Coop, 20550 Aretxabelata (Gipuzkoa) (ES); Mondragon Assembly, 84100 Orange (FR)
(72) Inventeur: BETTINELLI, Armand, 38054 GRENOBLE CEDEX 09 (FR); SOULAS, Romain, 38054 GRENOBLE CEDEX 09 (FR); GARCIA ECHEVARRIA, Gorka, ELORRIO BIZKAIA (ES); AGUERRE, Jean-Philippe, 64250 ITXASSOU (FR); HERNANDEZ MATEO, Xabier, IZQ (ES); FERNANDES DE ALMEIDA, Rui, 84100 ORANGE (FR); APRAIZ ARENAZA, Aitor, 20550 ARETXABALETA (ES)
(74) Mandataire: Cabinet Camus Lebkiri

(57) **Abrégé**

Un aspect de l'invention concerne un élément d'interconnexion (INTR) comportant deux portions distinctes, présentant chacune une surface plane (S1) orientée selon une direction (Y1), et séparée par une troisième portion présentant une section circulaire (CIRC).

## Description

### DOMAINE TECHNIQUE DE L'INVENTION

Le domaine technique de l'invention est celui des éléments d'interconnexion destinés à interconnecter des cellules photovoltaïques au sein d'une chaîne photovoltaïque.

### ARRIÈRE-PLAN TECHNOLOGIQUE DE L'INVENTION

Des cellules photovoltaïques peuvent être connectées en série entre elles afin de former une chaîne photovoltaïque. La chaîne photovoltaïque permet ainsi de générer, pour un même courant de court-circuit, une tension élevée. Une chaîne photovoltaïque peut comprendre une soixantaine des cellules photovoltaïques, connectées les unes aux autres au moyen d'une pluralité d'éléments conducteurs dits « éléments d'interconnexion ». Chaque élément d'interconnexion connecte par exemple une face supérieure d'une cellule à une face inférieure d'une autre cellule. La connexion électrique est réalisée par collage, au moyen d'un adhésif électriquement conducteur qui est réticulée, ou par soudage, au moyen d'un alliage conducteur provenant généralement du revêtement de l'élément d'interconnexion ou étant apporté. Ledit élément d'interconnexion peut présenter une section rectangulaire (on parle alors plutôt de ruban) ou une section circulaire (on parle alors plutôt de fil). Un ruban d'interconnexion (à section rectangulaire) offre une grande surface de contact pour réaliser la connexion électrique et/ou mécanique. Il produit toutefois une ombre portée sur les cellules qui réduit la production électrique finale de la chaîne photovoltaïque. Le fil (à section circulaire) réduit l'ombre portée grâce à sa faible largeur transverse et grâce aux réflexions des rayons lumineux sur sa surface courbe. En revanche, il présente deux inconvénients majeurs. D'une part, il offre une surface de contact faible pour réaliser le collage ou le soudage sur une face d'une cellule. D'autre part, sa faible surface de contact réduit l'adhésion mécanique dudit fil sur la cellule et augmente la résistance de contact.

Le document CN 104576767 A propose de palier à ces inconvénients en utilisant un fil d'interconnexion présentant un méplat s'étendant sur toute sa longueur. Dans le cas particulier présenté, le méplat offre une surface plus importante pour réaliser le soudage dudit fil conducteur sur une cellule, améliorant de la sorte l'adhésion mécanique et la résistance de contact. Puisque le fil conserve une section partiellement circulaire, l'ombrage est également réduit par rapport à un ruban de section rectangulaire. En revanche, la réduction de l'ombrage effectif du fil n'est pas aussi élevée qu'un fil de section parfaitement circulaire pourrait offrir.

Il existe donc un besoin de fournir un élément d'interconnexion offrant une bonne connexion mécanique et/ou électrique, tout en réduisant davantage son ombrage effectif.

### RÉSUMÉ DE L'INVENTION

Pour cela, l'invention concerne un élément d'interconnexion s'étendant selon une première direction, ledit élément d'interconnexion étant remarquable en ce qu'il comprend :
- des première et deuxième extrémités opposées ; et
- des première, deuxième et troisième portions s'étendant entre les première et deuxième extrémités,
   - la première portion présentant une première surface plane orientée selon une deuxième direction perpendiculaire à la première direction ;
   - la deuxième portion, distante de la première portion et de la deuxième extrémité, la deuxième portion présentant une deuxième surface plane orientée selon la deuxième direction ;
   - la troisième portion, entre la première portion de la deuxième portion, et présentant une section circulaire.

Chaque surface plane offre une surface de contact, mécanique et/ou électrique, plus importante que la surface offerte par un élément présentant uniquement une section circulaire constante. À la différence de l'élément d'interconnexion présenté dans l'art antérieur (CN 104576767 A), l'élément d'interconnexion selon l'invention présente, entre deux surfaces planes, une section entièrement circulaire. Cette section circulaire offre l'avantage de réduire au maximum l'ombrage qu'elle produit, grâce, notamment, aux réflexions qui peuvent se produire à sa surface. De plus cette section circulaire n'a pas été soumise à des contraintes de formage

Avantageusement, la première portion s'étend depuis la première extrémité. Alternativement, la première portion est distante de la première extrémité, préférentiellement d'au moins 0,5 mm et de moins de 12 mm, par exemple d'au moins 2 mm.

Avantageusement, la troisième portion sépare la première portion de la deuxième portion de la première portion. Autrement dit, elle s'étend de la première portion jusqu'à la deuxième portion.

Avantageusement, la section de la troisième portion est perpendiculaire à la première direction. Avantageusement, la troisième portion présente une section circulaire sur toute sa longueur (préférentiellement mesurée selon la première direction).

Avantageusement, une section de la première portion comprend un arc de cercle, au moins un segment de droite et deux segments de courbe, ledit au moins un segment de droite étant parallèle à une troisième direction perpendiculaire aux première et deuxième directions, les deux segments de courbes joignant l'arc de cercle et ledit au moins un segment de droite, l'aire de ladite section de la première portion étant égale à l'aire de la section de la troisième portion. La section de la première portion est avantageusement parallèle à la section de la troisième portion. Préférentiellement, une section de la deuxième portion présente également une aire égale à l'aire de la section de la troisième portion. Elle peut, pour cela, également comprend également un arc de cercle, au moins un segment de droite et deux segments de courbe joignant l'arc de cercle et ledit au moins un segment de droite. La section de la deuxième portion est ici aussi avantageusement parallèle à la section de la troisième portion.

Avantageusement, les première et deuxième surfaces planes sont tangentes à la troisième portion. Par tangent, on entend que les surfaces planes sont alignées avec une et seulement une génératrice de la troisième portion. Tangent s'entend à une erreur de mesure près ou une erreur de fabrication près. En effet, l'obtention des surfaces planes, par exemple par écrasement, peut montrer une déformation inverse (par exemple élastique), tendant à désaligner les surfaces planes et la génératrice de la troisième portion. On considère que les surfaces planes et la génératrice de la troisième portion sont alignées lorsqu'elles présentent un écart relatif, les unes par rapport aux autres, inférieur à 10 %, voire inférieur à 5 %, du diamètre de la section de la troisième portion.

Avantageusement, la section circulaire de la troisième portion présente un diamètre D, la première surface plane présente une première largeur mesurée selon une troisième direction perpendiculaire aux première et deuxième directions, ladite première largeur étant supérieure à 0,6×D, de préférence supérieure à 0,9×D.

Avantageusement, le diamètre D de la section circulaire de la troisième portion est compris entre 150 µm et 400 µm et préférentiellement entre 200 µm et 350 µm.

Avantageusement, la première portion présente une première hauteur, mesurée selon la deuxième direction comprise entre 0,60×D et 0,9×D, et préférentiellement entre 0,65×D et 0,80×D.

Avantageusement, la première portion présente une première longueur, mesurée selon la première direction, comprise entre 4 mm et 16 mm, et de préférence entre 6 mm et 10 mm.

Avantageusement, l'élément d'interconnexion comprend également :
- des quatrième, cinquième et sixième portions s'étendant entre les première et deuxième extrémités,
   - la quatrième portion présentant une troisième surface plane, orientée selon une direction opposée à la deuxième direction ;
   - la cinquième portion, distante de la quatrième portion et de la première extrémité, la cinquième portion présentant une quatrième surface plane orientée selon la direction opposée à la deuxième direction ; et
   - la sixième portion, entre la quatrième portion de la cinquième portion et présentant une section circulaire.

Avantageusement, la quatrième portion s'étend depuis la deuxième extrémité. Alternativement, la quatrième portion est distante de la deuxième extrémité, préférentiellement d'au moins 0,5 mm et de moins de 12 mm, par exemple d'au moins 2 mm.

Avantageusement, la sixième portion sépare la quatrième portion de la cinquième portion. Autrement dit, elle s'étend de la quatrième portion jusqu'à la cinquième portion.
Avantageusement, la section de la sixième portion est perpendiculaire à la première direction. Avantageusement, la sixième portion présente une section circulaire sur toute sa longueur.
Avantageusement, la deuxième portion et la quatrième portion se confondent au moins partiellement.

Alternativement, la deuxième portion et la cinquième portion sont distantes l'une de l'autre et préférentiellement d'au moins 0,5 mm et encore préférentiellement de moins de 2 mm.

Avantageusement, la deuxième portion présent une deuxième surface plane additionnelle, opposée à la deuxième surface plane. De la même manière, la première portion peut présenter une première surface plane additionnelle, opposée à la première surface plane.

Avantageusement, les quatrième et/ou cinquième portions présentent également des quatrième et/ou cinquième surfaces planes additionnelles, opposées aux quatrième et/ou cinquième surfaces planes.

L'invention concerne en outre une chaîne photovoltaïque comprenant des première et deuxième cellules photovoltaïques, la deuxième cellule photovoltaïque étant connectée électriquement à la première cellule photovoltaïque, les deux cellules photovoltaïques sont parallèles à un plan, la première cellule photovoltaïque comprenant :
- des premier et deuxième bords opposés ;
- une première face, orientée selon une quatrième direction perpendiculaire audit plan, ladite première face comprenant une première pluralité de portions destinées à être connectées à un élément d'interconnexion, la première pluralité de portions à connecter étant distribuée entre le premier bord et le deuxième bord suivant une cinquième direction perpendiculaire à la quatrième direction.

La chaîne photovoltaïque est remarquable en ce qu'elle comprend au moins un élément d'interconnexion selon le premier aspect de l'invention, s'étendant en partie sur la première face et sur la première pluralité de portions à connecter, ledit au moins un élément d'interconnexion s'étendant, selon la cinquième direction, au-delà du deuxième bord de manière à atteindre la deuxième cellule photovoltaïque, la première surface de la première portion dudit au moins un élément d'interconnexion étant connectée sur une première portion à connecter de la première pluralité de portions à connecter, la deuxième surface de la deuxième portion dudit au moins un élément d'interconnexion étant connectée sur une deuxième portion à connecter de la première pluralité de portions à connecter.

Avantageusement, la première portion à connecter est la portion de la première pluralité de portions à connecter la plus proche du premier bord et la deuxième portion à connecter est la portion de la première pluralité de portions à connecter la plus proche du deuxième bord.

Avantageusement, les première et deuxième portions à connecter de la première pluralité de portions à connecter présentent une surface libre et/ou une surface métallisée.

Avantageusement, la chaîne photovoltaïque comprend également de la pâte adhésive conductrice adhérant à chacune des première et deuxième portions à connecter de la première pluralité de portions à connecter et à l'élément d'interconnexion, l'épaisseur de ladite pâte adhésive conductrice étant préférentiellement inférieure à 70 µm et de manière encore préférée, inférieure à 40 µm.

Avantageusement, la chaîne photovoltaïque comprend également un alliage conducteur soudé à chacune des première et deuxième portions de la première pluralité de portions à connecter et à l'élément d'interconnexion.

Avantageusement, la deuxième cellule photovoltaïque comprend :
- des troisième et quatrième bords opposés, le troisième bord étant parallèle et en vis-à-vis du deuxième bord de la première cellule photovoltaïque ;
- une deuxième face, orientée selon une direction opposée à la quatrième direction, ladite deuxième face comprenant une deuxième pluralité de portions à connecter, distribuée entre le troisième bord et le quatrième bord suivant la cinquième direction.

Ledit au moins un élément d'interconnexion s'étend avantageusement selon la cinquième direction sur la deuxième face et sur la deuxième pluralité de portions à connecter, la troisième surface de la quatrième portion dudit au moins un élément d'interconnexion étant connectée sur une quatrième portion à connecter de la deuxième pluralité de portions à connecter, la quatrième surface de la cinquième portion dudit au moins un élément d'interconnexion étant connectée sur une troisième portion à connecter de la deuxième pluralité de portions à connecter.

Avantageusement, la quatrième portion à connecter de la deuxième pluralité de portions à connecter est la portion plus proche du quatrième bord et la troisième portion de la deuxième pluralité de portions à connecter est la portion la plus proche du troisième bord.

L'invention concerne également un procédé de fabrication d'un élément d'interconnexion comprenant les étapes suivantes :
- fournir un fil conducteur, s'étendant selon une première direction, présentant une section circulaire sur toute sa longueur ;
- former, au niveau d'une première portion dudit fil conducteur, une première surface plane orientée selon une deuxième direction perpendiculaire à la première direction ;
- former, au niveau d'une deuxième portion, distante de la première portion, une deuxième surface plane orientée selon la deuxième direction, une troisième portion, disposée entre les première et deuxième portions présentant une section circulaire et ;
- couper le fil conducteur de manière à former des première et deuxième extrémités opposées, les première, deuxième et troisième portions s'étendant entre les première et deuxième extrémités, la deuxième portions étant distante de la deuxième extrémité dudit fil conducteur.

Avantageusement, le fil conducteur comprend, avant les étapes de formation des première et deuxième surfaces planes, un revêtement d'alliage fusible.

Avantageusement, les première et/ou deuxième surfaces planes sont formées par écrasement du fil conducteur au niveau des, respectivement, première et/ou deuxième portions. L'écrasement du conducteur ne nécessite pas de moyens complexes telles que des filières de tréfilage. De plus, il n'est pas nécessaire de modifier de manière substantielle les équipements mis en oeuvre lorsque le diamètre initial ou/et le matériau constituant le conducteur changent. De plus, l'élément d'interconnexion peut être obtenu à partir d'un conducteur présentant, avant écrasement, un revêtement, par exemple d'alliage fusible.

Avantageusement, la pression appliquée sur le fil conducteur lors de l'écrasement est comprise entre 250 N/mm² et 700 N/mm².

L'invention concerne aussi un procédé de fabrication d'une chaîne photovoltaïque comprenant les étapes suivantes :
- fournir des première et deuxième cellules photovoltaïques, les deux cellules photovoltaïques étant parallèles à un plan, la première cellule photovoltaïque comprenant :
   - des premier et deuxième bords opposés ;
   - une première face, orientée selon une quatrième direction, perpendiculaire audit plan, ladite première face comprenant une première pluralité de portions destinées à être connectées à un élément d'interconnexion, la première pluralité de portions à connecter étant distribuée entre le premier bord et le deuxième bord suivant une cinquième direction perpendiculaire à la quatrième direction ;
- interconnecter la deuxième cellule photovoltaïque à la première cellule photovoltaïque au moyen d'au moins un élément d'interconnexion selon le premier aspect de l'invention, ledit au moins un élément d'interconnexion étant déposé sur la première face de la première cellule photovoltaïque de sorte qu'il s'étende en partie sur ladite première face et sur la première pluralité de portions à connecter, et de sorte qu'il s'étende, selon la cinquième direction, au-delà du deuxième bord jusqu'à atteindre la deuxième cellule photovoltaïque, la première surface de la première portion dudit au moins un élément d'interconnexion étant connectée sur une première portion à connecter de la première pluralité de portions à connecter et la deuxième surface de la deuxième portion dudit au moins un élément d'interconnexion étant connectée sur une deuxième portion à connecter de la première pluralité de portions à connecter.

Avantageusement, l'étape d'interconnexion comprend les étapes suivantes
- déposer une portion de pâte adhésive conductrice sur chacune des première et deuxième portions à connecter ; et
- presser :
   - la première surface de la première portion dudit au moins un élément d'interconnexion sur la portion de pâte adhésive conductrice disposée sur la première portion à connecter ; et
   - la deuxième surface de la deuxième portion dudit au moins un élément d'interconnexion sur la portion de pâte adhésive conductrice disposée sur la deuxième portion à connecter.

Avantageusement, le procédé de fabrication comprend, après l'interconnexion, l'étape complémentaire suivante : traiter thermiquement au moins la première cellule photovoltaïque et ledit au moins un élément d'interconnexion, une pression étant exercée au niveau de chacune des première et deuxième portions dudit au moins un élément d'interconnexion selon une direction opposée à la quatrième direction, lors de ladite étape de traitement, la pression étant préférentiellement supérieure à 1 N/mm².

Avantageusement, le procédé de fabrication de la chaîne photovoltaïque comprend également, avant l'étape d'interconnexion, une étape de fabrication dudit au moins un élément d'interconnexion suivant le procédé de fabrication d'un élément d'interconnexion selon l'invention.

L'invention concerne également un dispositif de fabrication d'un élément d'interconnexion comprenant des moyens adaptés pour réaliser les étapes du procédé de fabrication d'un élément d'interconnexion selon l'invention.

Les moyens comprennent par exemple un guide et une enclume configurés pour former les première et deuxième surfaces planes par écrasement du fil conducteur au niveau d'une première portion et d'une deuxième portion.

L'invention concerne également un programme d'ordinateur comprenant des instructions qui conduisent le dispositif selon l'invention à exécuter les étapes du procédé de de fabrication d'un élément d'interconnexion selon l'invention.

L'invention concerne également un support lisible par ordinateur, sur lequel est enregistré le programme d'ordinateur précité.

L'invention concerne aussi un équipement de fabrication d'une chaîne photovoltaïque comprenant :
- un manipulateur de cellules photovoltaïques configuré pour agencer des première et deuxième cellules photovoltaïques dans un plan et orienter une première face de la première cellule photovoltaïque selon une quatrième direction, perpendiculaire audit plan ;
- un manipulateur d'éléments d'interconnexion comprenant un moyen d'alignement, configuré pour déposer au moins un élément d'interconnexion sur la première face de la première cellule photovoltaïque de sorte qu'il s'étende en partie sur ladite première face et sur une première pluralité de portions à connecter de la première face, et de sorte qu'il s'étende selon une cinquième direction jusqu'à atteindre la deuxième cellule photovoltaïques, la première surface de la première portion dudit au moins un élément d'interconnexion étant disposée sur une première portion à connecter de la première pluralité de portions à connecter et la deuxième surface de la deuxième portion dudit au moins un élément d'interconnexion étant disposée sur une deuxième portion à connecter de la première pluralité de portions à connecter ; et
- un moyen de connexion configuré pour connecter la première surface de la première portion dudit au moins un élément d'interconnexion sur la première portion à connecter de la première pluralité de portions à connecter ; et connecter la deuxième surface de la deuxième portion dudit au moins un élément d'interconnexion sur la deuxième portion à connecter de la première pluralité de portions à connecter.

Avantageusement, l'équipement comprend un dispositif de fabrication selon l'invention.

L'équipement peut également comprendre un moyen de pression capable d'exercer une pression au niveau de chacune des première et deuxième portions dudit au moins un élément d'interconnexion selon une direction opposée à la quatrième direction lors de l'étape de traitement, la pression étant préférentiellement supérieure à 1 N/mm².

L'invention concerne également un programme d'ordinateur comprenant des instructions qui conduisent l'équipement selon l'invention à exécuter les étapes du procédé de fabrication d'une chaîne photovoltaïque selon l'invention.

L'invention concerne également un support lisible par ordinateur, sur lequel est enregistré le programme d'ordinateur précité.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
Les figures 1 à 4 montrent des premier, deuxième et troisième modes de réalisation d'un élément d'interconnexion selon l'invention.
La figure 5 montre un exemple de collage de l'élément d'interconnexion de la figure 1 sur une cellule photovoltaïque.
Les figures 6 à 8 illustrent un premier mode de mise en oeuvre d'un procédé de fabrication de l'élément d'interconnexion des figures 1 et 2.
La figure 9 illustre un deuxième mode de mise en oeuvre du procédé de fabrication de l'élément d'interconnexion.
Les figures 10 et 11 montrent un quatrième mode de réalisation de l'élément d'interconnexion selon l'invention, issu du procédé de la figure 9.
Les figures 12 et 13 montrent un cinquième mode de réalisation de l'élément d'interconnexion selon l'invention.
La figure 14 montre un principe de fabrication de l'élément d'interconnexion des figures 12 et 13.
La figure 15 montre un sixième mode de réalisation de l'élément d'interconnexion selon l'invention.
La figure 16 montre un exemple de soudage de l'élément d'interconnexion de la figure 15 sur une cellule photovoltaïque.
Les figures 17 à 20 montrent des septième, huitième, neuvième et dixième modes de réalisation de l'élément d'interconnexion selon l'invention.
Les figures 21 et 22 montrent des premier et deuxième modes de réalisation d'une chaîne photovoltaïque selon l'invention.
La figure 23 montre schématiquement un mode de mise en oeuvre d'un procédé de fabrication d'une chaîne photovoltaïque selon l'invention.
La figure 24 montre schématiquement un mode de réalisation d'un équipement selon l'invention.

### DESCRIPTION DÉTAILLÉE

Un premier aspect de l'invention concerne un élément d'interconnexion. Ledit élément d'interconnexion permet d'augmenter l'adhésion mécanique et/ou le contact électrique au sein d'une chaîne photovoltaïque tout en réduisant l'ombrage de ce dernier sur une cellule photovoltaïque.

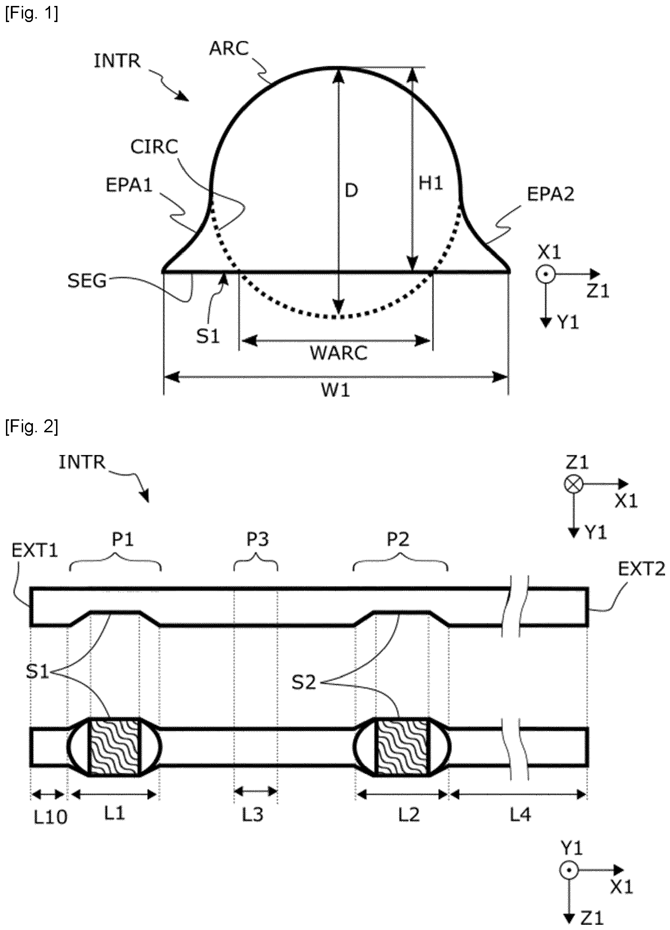

Les figures 1 et 2 montrent, selon trois vues différentes, un premier mode de réalisation d'un élément d'interconnexion INTR selon l'invention.

Ledit élément d'interconnexion INTR s'étend selon une première direction X1, illustrée sur les figures. Ledit élément d'interconnexion INTR comprend des première et deuxièmes extrémités EXT1, EXT2, disposées de part et d'autre dudit élément INTR.

L'élément d'interconnexion INTR comprend une première portion P1 et une deuxième portion P2. La première portion P1 s'étend sur une longueur L1. Elle est notamment distante de la première extrémité EXT1 de l'élément INTR, d'une longueur L10 pouvant être comprise entre 0,5 mm et 12 mm, voire jusqu'à 15 mm. La deuxième portion P2 s'étend sur une longueur L2. La deuxième portion P2 est distante de la deuxième extrémité EXT2 d'une longueur L4. La deuxième portion P2 est distante de la première portion P1 et de la deuxième extrémité EXT2.

Une troisième portion P3 s'étend entre la première portion P1 et la deuxième portion P2. La troisième portion P3 s'étend sur une longueur L3. Dans le mode de réalisation de la figure 2, la portion P3 est distante des première et deuxième portions P1, P2.

La première portion P1 présente une première surface plane S1, orientée selon une deuxième direction Y1 perpendiculaire à la première direction X1. De la même manière, la deuxième portion P2 présente également une deuxième surface plane S2, orientée selon la deuxième direction Y1. La troisième portion P3 présente, quant à elle, une section circulaire CIRC constante. Par « constante », on entend sur toute sa longueur. Dans le mode de réalisation de la figure 2, la portion P3 est distante des première et deuxième portions P1, P2, ce qui signifie qu'entre les portions P1 et P3 et entre les portions P2 et P3, l'élément d'interconnexion peut présenter une section non circulaire.

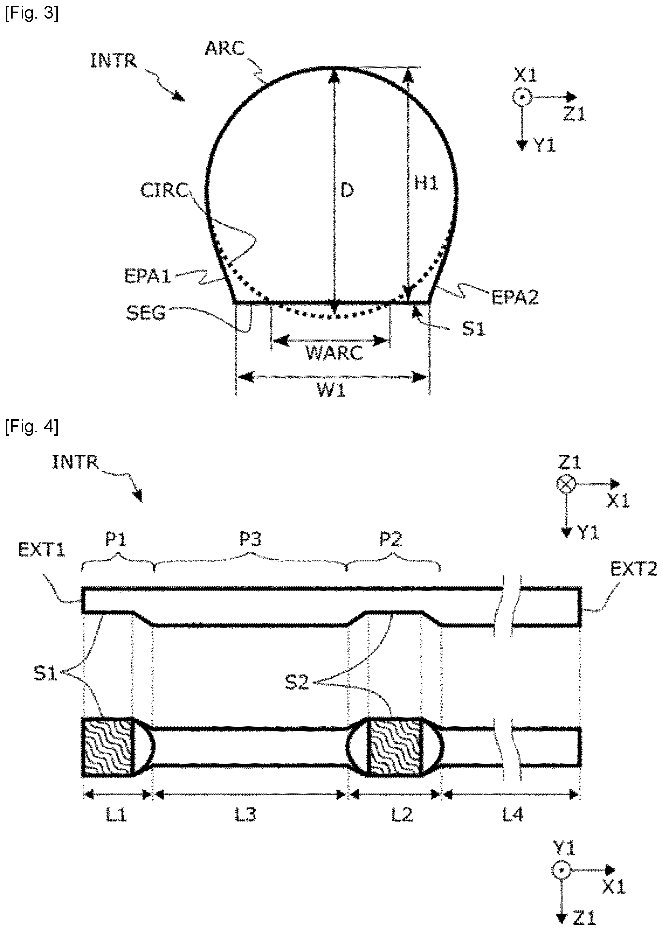

De manière avantageuse (telle qu'illustrée par la figure 4), la troisième portion P3 s'étend de la première portion P1 jusqu'à la portion P2.

Les première et deuxième portions P1, P2 résultent par exemple d'un écrasement localisé dudit élément d'interconnexion INTR. Par exemple, l'élément d'interconnexion INTR présente initialement une section circulaire CIRC sur une partie au moins de sa longueur (là où seront disposé les portions P1, P2 et P3) et de préférence sur toute sa longueur. Il peut s'agir d'un fil conducteur initialement cylindrique. L'élément d'interconnexion INTR, illustré par les figures 1 et 2, peut alors résulter de l'écrasement dudit fil au niveau des première et deuxième portions P1, P2 de manière à former les deux surfaces planes S1, S2. La troisième portion P3 reste intacte et conserve alors sa section circulaire.

La figure 1 montre plus particulièrement une section dudit conducteur, selon un plan {Y1 ; Z1}, au niveau de la première portion P1. Le contour en trait pointillé correspond à la section circulaire CIRC dudit élément INTR au niveau de la troisième portion P3, ladite section étant parallèle au plan {Y1 ; Z1}. Le contour en trait plein correspond à la section de l'élément INTR au niveau de la première portion P1. Dans cet exemple, la surface plane S1 a été réalisée par un écrasement sur la partie « basse » du conducteur, c'est à dire selon la direction -Y1. Le contour en train plein montre un arc de cercle qui se confond en partie avec le contour pointillé. Le contour en train plein montre également un segment de droite SEG, s'étendant selon une troisième direction Z1. Ce segment de droite appartient à la surface S1, qui s'étend dans le plan {X1 ; Z1}. Le contour en trait plein montre également deux segments de courbes EPA1, EPA2, joignant l'arc de cercle ARC et le segment de droite SEG. Ces deux segments de courbes EPA1, EPA2 forment deux épaules correspondent à la matière qui peut se trouver sur les bords de l'élément INTR et forme en partie la surface plane S1. Il s'agit par exemple de la matière poussée sur les bords de l'élément lors de sa mise en forme, lorsque celle-ci est réalisée par écrasement. En négligeant le changement de volume du matériau qui peut avoir lieu lors de l'écrasement, l'aire entourée par le contour en pointillé est égale à l'aire entourée par le contour en trait plein.

Une section au niveau de la deuxième portion P2, suivant un plan parallèle au plan {Y1 ; Z1}, montrerait préférentiellement le même type de section que celui représenté en trait plein dans la figure 1.

La figure 2 montre une vue de côté (dans le plan {X1 ; Y1}) et une vue de dessous (dans le plan {X1 ; Z1}) d'une partie dudit élément INTR. La vue de dessous permet notamment de distinguer les première et deuxième surfaces planes S1, S2 (hachures ondulées). L'épaisseur de l'élément INTR, mesurée selon Y1, au niveau des première et deuxième portions P1, P2, est réduite par rapport à l'épaisseur de l'élément INTR au niveau de la troisième portion P3. Cette réduction localisée de l'élément INTR résulte, par exemple, de son écrasement. La largeur des surfaces planes S1, S2, mesurées selon Z1 est avantageusement supérieure à la largeur de l'élément INTR (autrement dit son diamètre) au niveau de la troisième portion P3. Selon une alternative, la largeur des surfaces planes S1, S2 peut être inférieure à la largeur de l'élément INTR.

La figure 3 illustre par exemple un mode de réalisation de l'élément dans lequel la largeur W1 de la surface plane S1 est inférieure au diamètre D de l'élément. L'élément présente toutefois une surface plane suffisamment large pour améliorer sa connexion sur une cellule photovoltaïque.

Chaque portion P1, P2 (telle que représentée par la figure 2) peut présenter au moins une partie biseautée, plus ou moins prononcée. Chaque partie biseautée relie une des surfaces planes S1, S2 à la partie cylindrique de la troisième portion P3. Elle peut également résulter de l'écrasement de l'élément INTR.

La figure 4 montre un mode de réalisation dans lequel la première portion P1 s'étend depuis la première extrémité EXT1 de l'élément INTR et sur une longueur L1.

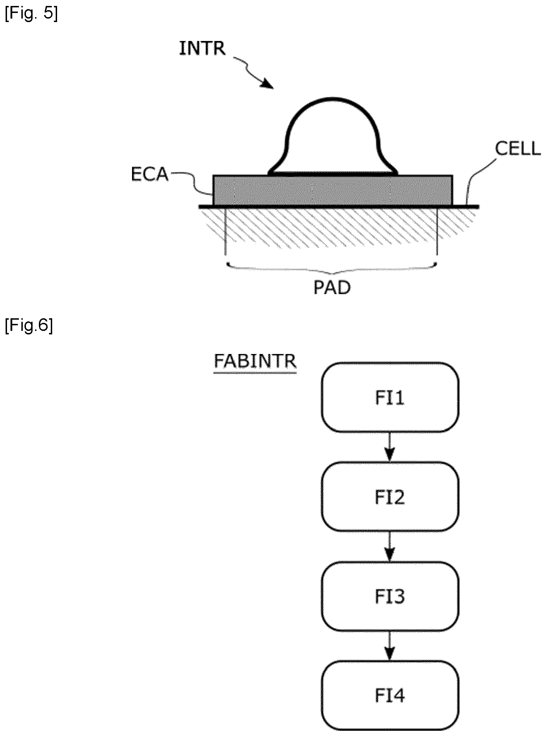

La figure 5 montre, selon une vue en coupe, un exemple de collage de l'élément d'interconnexion INTR selon l'une des figures 1, 2 ou 4 sur une portion PAD d'une cellule photovoltaïque CELL. Le collage est réalisé au moyen d'une portion d'adhésif ECA, pouvant être un adhésif électriquement conducteur. La portion d'adhésif réalise la connexion mécanique et préférentiellement la connexion électrique de l'élément d'interconnexion sur la cellule CELL. L'élément d'interconnexion INTR offre des surfaces de collage S1, S2 plus importante qu'un conducteur uniquement cylindrique. La force d'adhésion, proportionnelle à la surface collée, est donc augmentée. La probabilité de décollement, par exemple par arrachage (« peeling » en anglais), est donc réduite.

En pratique la portion d'adhésif ECA est généralement déposé sur la cellule avant le report d'un élément d'interconnexion INTR. Du fait de l'imprécision de l'alignement de l'élément INTR, il convient de déposer une portion d'adhésif ECA qui soit très large de manière à être sûr que l'élément d'interconnexion sera bien localisé sur la portion d'adhésif mais la force d'adhésion reste proportionnelle à la surface de l'élément INTR en contact avec l'ECA. L'augmentation de la largeur de la surface plane S1 permet à l'élément d'interconnexion INTR d'offrir une meilleure adhésion.

L'art antérieur comprend un conducteur présentant une surface plane (décrit comme un méplat s'étirant sur toute la longueur du conducteur). Toutefois cette surface plane ne présentent pas les épaules EPA1, EPA2 de chaque côté, telles que représentées sur les figures 1 ou 3. Au contraire, la surface plane suit un arc inscrit dans une section circulaire du conducteur. La surface plane sans épaules EPA1, EPA2 présente donc une largeur maximum WARC, mesurée suivant Z1, qui est inférieure à la largeur W1 de la surface plane S1.

Les surfaces planes S1, S2 offrent donc une résistance de contacte réduite, par rapport à un conducteur uniquement cylindrique ou présentant une surface plane de largeur WARC.

La troisième portion P3 présente une section circulaire de diamètre D. Ledit diamètre D peut être compris entre 150 µm et 400 µm, voire entre 200 µm et 350 µm. Lorsque les surface planes S1, S2 sont obtenues par écrasement de l'élément INTR, la largeur de chaque surface S1, S2 dépend du diamètre initial du conducteur (égale au diamètre D au niveau de la troisième portion P3) et de sa réduction de hauteur (mesurée selon Y1). En effet, plus l'élément INTR est écrasé, plus une quantité importante de matière est reportée dans les épaules délimitées par les segments de courbes EPA1, EPA2, augmentant d'autant la largeur de chaque surface plane S1, S2. Les figures 1 et 3 montrent par exemple, la hauteur H1 de la première portion P1 et la largeur W1 de la première surface plane S1 pour deux écrasements différents. Ladite hauteur est mesurée selon la direction Y1 (avantageusement parallèle à la direction de l'écrasement). La quantité de matière reportée dans les épaules EPA1, EPA2 est issue de la portion de cercle de hauteur D - H1.

La hauteur H1, mesurée selon la direction -Y1, est avantageusement comprise entre 0,60×D et 0,9×D. En considérant que la troisième portion P3 présente un diamètre initial D = 350 µm, la hauteur H1 est alors comprise entre 210 µm et 315 µm. De manière préférée, la hauteur H1 est comprise entre 0,75×D et 0,85×D.

La première surface plane S1 présente une largeur W1 avantageusement supérieure à 0,6×D (cas de la figure 3) et préférentiellement, supérieure à 0,9×D, par exemple 1,4×D (cas de la figure 1).

Chaque portion P1, P2 présente avantageusement une longueur L1, L2 comprise entre 4 mm et 16 mm. De la sorte, la surface totale offerte par les première et deuxième surfaces planes S1, S2 améliore de manière significative son adhésion sur une cellule. Les longueurs L1 et L2 sont de préférence choisies entre 6 mm et 10 mm.

La troisième longueur L3 de la troisième portion P3 dépend avantageusement d'une dimension de la cellule photovoltaïque sur laquelle sera connecté l'élément d'interconnexion. Les première et deuxième surfaces S1, S2 de l'élément d'interconnexion INTR peuvent être placés au voisinage des bords de la cellule. La longueur maximale de la troisième portion P3 est donc choisie de manière à respecter ce critère. Par exemple, pour une demi-cellule provenant d'une cellule au format « G12 », c'est-à-dire présentant une longueur de ½ × 210 = 105 mm, la longueur L3 pourra être au maximum de 97 mm (105 mm - 2 × 4mm si les surfaces planes s'étendent chacune sur 4 mm et sont placées au niveau des bords).

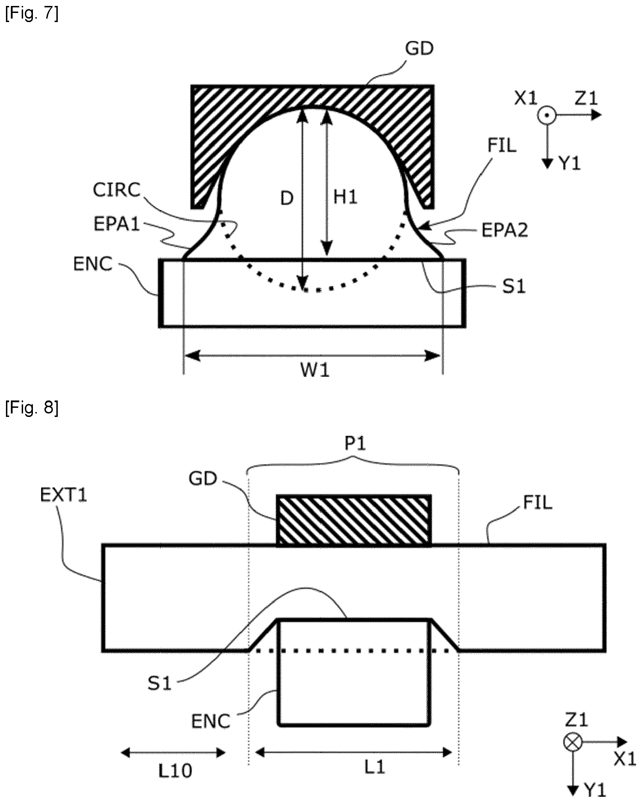

Les figures 6 à 8 illustrent un procédé de fabrication FABINTR de l'élément d'interconnexion des figures 1 et 2 (dont la portion P1 est distance de la première extrémité EXT1). Ledit procédé FABINTR comprend, dans un premier temps, une étape de fourniture FI1 d'un fil conducteur FIL. Ledit fil conducteur FIL est destiné à former l'élément d'interconnexion INTR une fois mis en forme. Il présente pour cela une section circulaire sur une partie au moins de sa longueur et avantageusement sur toute sa longueur. Le fil conducteur peut présenter, d'ores et déjà, des premières et deuxièmes extrémités EXT1, EXT2. Toutefois, il peut être avantageux de couper FI4 le fil après la formation FI2, FI3 des première et deuxième portions P1, P2 et de leurs surfaces planes S1, S2. Le fil est préférablement droit et s'étend selon la première direction X1. Le procédé FABINTR comprend la formation, au niveau d'une première portion P1 dudit fil, d'une première surface plane S1 orientée selon la deuxième direction Y1, perpendiculaire à la première direction X1. L'étape de formation FI2 comprend par exemple l'écrasement du fil conducteur FIL, représentée par les figures 7 à 8. L'écrasement est réalisé au niveau de la première portion P1 dudit fil (donc sur une longueur L1 et en l'occurrence distante d'une extrémité du fil). Il est réalisé de manière à former la première surface plane S1, orientée selon la direction Y1.

Les figures 7 et 8 montrent, selon deux vues en coupe, un exemple de mise en oeuvre de l'étape d'écrasement du procédé de fabrication FABINTR. Le fil conducteur FIL est inséré dans un guide GD qui prend appuie sur la surface supérieure dudit fil. Le guide GD entoure par exemple la moitié supérieure dudit fil (qui formera l'arc de cercle dans la section de la première portion P1). Une pièce ENC (que l'on appellera également « enclume »), présentant une surface plane dans le plan {X1 ; Z1}, vient au contact dudit fil conducteur FIL en suivant la direction -Y1 et écrase le fil conducteur FIL dans le guide GD. Le fil, coincé entre le guide GD et l'enclume ENC, se déforme. La matière repoussée sur les côtés par l'enclume ENC forme les épaules EPA1, EPA2.

Le guide peut également présenter une forme évasée, s'ouvrant selon la direction Y1, ceci afin de faciliter la formation des épaules EPA1, EPA2. Ainsi, il y a un peu plus de place pour le fluage de la matière sur les côtés du fil. Une section du guide GD présente par exemple un demi-cercle et deux segments de droite s'étendant, depuis les extrémités du demi-cercle, vers l'extérieur du guide, à la manière d'un 'V' inversé.

La pression appliquée par l'enclume ENC sur le fil dépend du matériau utilisé. Elle est préférentiellement comprise entre 250 N/mm² et 700 N/mm². Dans un exemple, une pression de 430 N/mm² est appliquée sur un fil de cuivre présentant un diamètre de 350 µm et une longueur de 5 mm (ce qui correspond à une force totale de 750 N). Une telle pression permet de réaliser une surface plane présentant une largeur de 350 µm (donc égale au diamètre initial du fil).

Le document CN 103537496 B divulgue par exemple un procédé de fabrication d'un ruban métallique de section rectangulaire. Le même principe peut être appliqué au fil du document CN 104576767 A (cité dans l'art antérieur) afin de former le méplat le long du fil. La mise en forme du ruban divulguée est réalisée par tréfilage dans une pluralité de filières chargée de réduire la section totale du fil et mettre en forme différentes faces planes du fil. Toutefois, le tréfilage nécessite une traction continue de la matière à travers les filières, nécessitant une puissance mécanique substantielle. De plus, ce type de procédé peut provoquer la rupture de fil fins. Le tréfilage n'est pas non plus compatible avec un fil présentant déjà un revêtement, tel qu'un revêtement en alliage fusible, puisque le revêtement serait arraché et/ou remélangé avec le matériau constituant le fil conducteur (le revêtement peut présenter une épaisseur comprise entre 2 µm et 3 µm). Le tréfilage est également un procédé qui nécessite l'ajustement de plusieurs paramètres opératoires (tels que la force de traction et/ou les diamètres et le nombre des filières) rendant complexe le changement de caractéristique du fil (tel que son diamètre) ou le changement de matériau constituant ledit fil.

Le procédé de fabrication FABINTR selon l'invention offre en revanche une simplicité de mise en oeuvre. En effet, il n'est pas nécessaire de recourir au tréfilage. Le procédé peut également être réalisé à partir d'éléments d'interconnexion filaires pouvant présenter des diamètres ou des matériaux différents. Le procédé FABINTR peut également former les surfaces planes S1, S2 à partir d'un conducteur présentant déjà un revêtement en alliage fusible sans que celui-ci ne soit arraché ou remélanger.

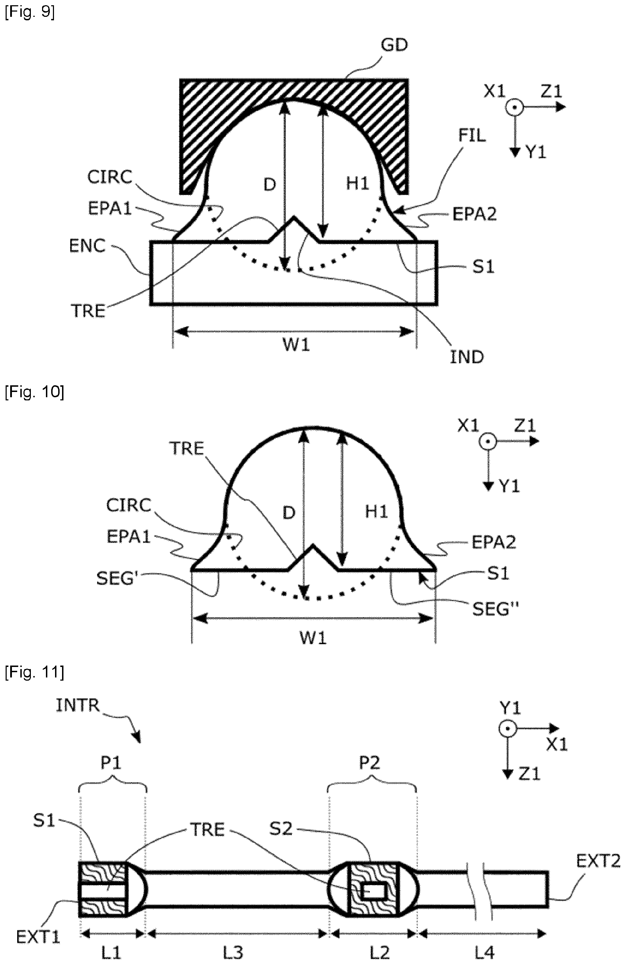

La figure 9 montre une variante de l'étape de formation des surfaces planes des figures 7 et 8 dans laquelle l'enclume ENC une partie saillante IND, s'étendant préférentiellement selon la première direction X1. Cette partie saillante IND, appelée « poinçon », pénètre dans la matière du fil lors de l'écrasement. Elle facilite notamment le report de matière sur les côtés du fil, de manière à former les épaules EPA1, EPA2.

Les figures 10 et 11 montre un mode de réalisation de l'élément d'interconnexion INTR obtenu par l'écrasement selon la figure 9, au moyen du poinçon. L'élément INTR présente, au niveau des première et deuxième portions P1, P2, une tranchée, pouvant séparer la surface plane en deux parties.

La figure 10 montre par exemple la section de la première portion P1 qui comprend deux segments de droite SEG', SEG", alignés selon la troisième direction Z1. Chaque segment SEG', SEG" est relié à un segment de courbe EPA1, EPA2.

La figure 11 montre les première et deuxième surfaces planes S1, S2. La première surface plane S1 présente une tranchée TRE qui s'étend sur toute la longueur de la surface, selon la première direction X1. La deuxième surface plane S2 présente une tranchée TRE qui s'étend sur une partie seulement de la longueur de la surface.

La tranchée TRE permet d'augmenter la largeur W1 de la surface plane S1 sans toutefois écraser davantage le fil conducteur. De plus, puisque la profondeur de la tranchée est contrôlée (discuté ci-après), elle participe également au collage/soudage. La surface participant à l'adhésion est donc nettement augmentée.

La tranchée peut présenter une profondeur, mesurée selon la deuxième direction Y1, depuis la surface plane, inférieure ou égale à 1/3×D (où D est le diamètre de la section de la troisième portion P3, c'est aussi le diamètre initial du conducteur avant écrasement). Pour un élément INTR présentant un diamètre de 350 µm, la profondeur de la tranchée TRE peut être de 100 µm. Avantageusement, la profondeur de la tranchée est comprise entre 1/6×D et 1/3×D. La tranchée est relativement profonde et elle peut permettre à de l'adhésif ou de l'alliage à souder de pénétrer dans la trancher et s'étendre contre une surface sensiblement plus grande.

La profondeur de la tranchée peut également être inférieure à 1/6×D. De la sorte, une quantité réduite d'adhésif ou d'alliage pénètre dans la tranchée ce qui permet d'éviter un fluage incontrôlé des moyens de collage/soudage pendant la connexion sur une cellule photovoltaïque.

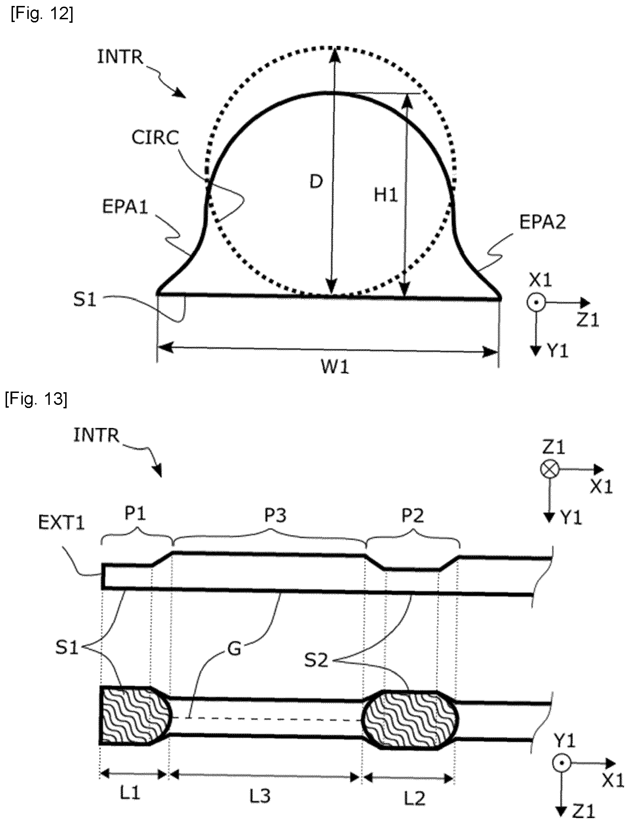

Les figures 12 et 13 montrent un deuxième mode de réalisation de l'élément d'interconnexion INTR dans lequel, les première et deuxième surfaces planes S1, S2 sont tangentes à la section circulaire CIRC (en pointillée dans la figure 12) de la troisième portion P3. De la sorte, l'élément d'interconnexion INTR ne présente pas de changement de niveau entre les surfaces planes S1, S2 et la troisième portion P3. L'élément INTR peut être posé sur une surface plate, telle qu'une cellule photovoltaïque, en ne laissant qu'un jour réduit, voire nul. La connexion de l'élément INTR sur une cellule est ainsi facilitée.

Lorsque les surfaces sont tangentes avec la troisième portion P3, elles sont alignées avec une seule génératrice G (illustrée sur la figure 13) de la portion P3. L'alignement des surfaces planes S1, S2 avec la génératrice G. En revanche, l'écrasement peut être élastoplastique et montrer une déformation inverse après alignement des surfaces et de la génératrice. L'écart entre les surfaces et la génératrice est alors avantageusement compensé par pressage lors de la connexion de l'éléments INTR sur une cellule.

Les première et deuxième surface planes S1, S2 (hachures ondulées dans la figure 13) peuvent également présenter une surface légèrement plus grande que celles des modes de réalisation des figures 2 et 4. En effet, les portions P1, P2 dans les figures 2 et 4 montrent des biseaux entre les surfaces planes et les surfaces courbes (par exemple au niveau de la troisième portion P3). Ces biseaux sont absents de l'élément INTR dans le mode de réalisation de la figure 13 car les surfaces planes sont tangentes à la principale surface courbe. L'aire des première et deuxième surfaces planes S1, S2 est donc légèrement augmentée (elle comprend l'air des parties initialement biseautées).

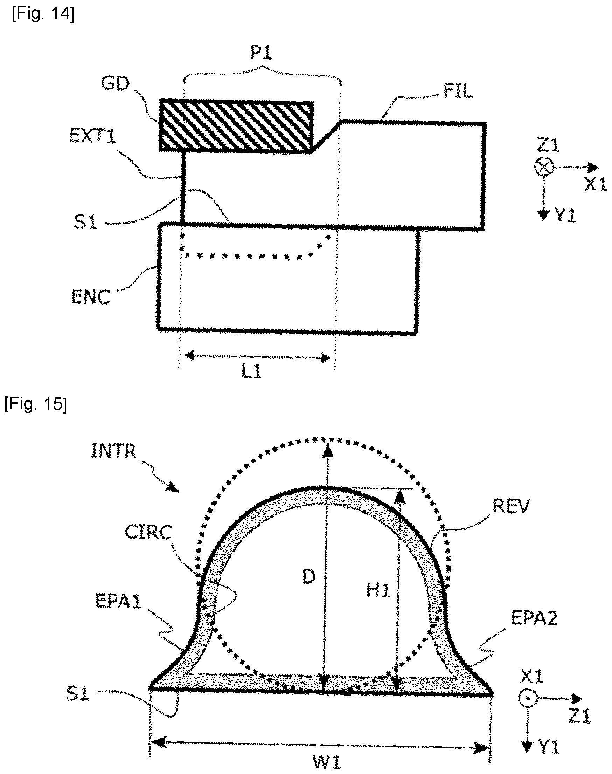

La figure 14 montre un mode de mise en oeuvre de l'étape d'écrasement FI2, permettant de réaliser la première surface plane S1. À la différence du mode de mise en oeuvre illustré par les figures 5 et 6, l'ensemble comprenant le guide GD et l'enclume ENC subissent une translation permettant de compenser la déformation du fil conducteur FIL. L'écrasement peut également être obtenu par une pression du guide GD sur le fil, sans mouvement de l'enclume ENC. L'enclume ENC s'étend avantageusement la première portion P1 et sous une partie au moins de la troisième portion P3. De la sorte, la génératrice G de la troisième portion P3 est plus facilement alignée avec la surface plane S1 formée.

La figure 15 montre un mode de réalisation de l'élément d'interconnexion INTR dans lequel, l'élément INTR comprend, avant mise en forme, un revêtement d'alliage fusible REV. Le revêtement d'alliage fusible REV permet de réaliser un soudage sans apport de matière. La mise en oeuvre du procédé de fabrication FABINTR selon l'invention, par exemple par écrasement, permet de conserver le revêtement fusible autour de l'élément INTR. Lorsque le fil présente un revêtement REV, il est préférable que l'écrasement soit limité, tel que celui représenté à la figure 3. En effet, un écrasement conséquent peut endommager le revêtement REV au niveau des angles aigües des épaules EPA1, EP2.

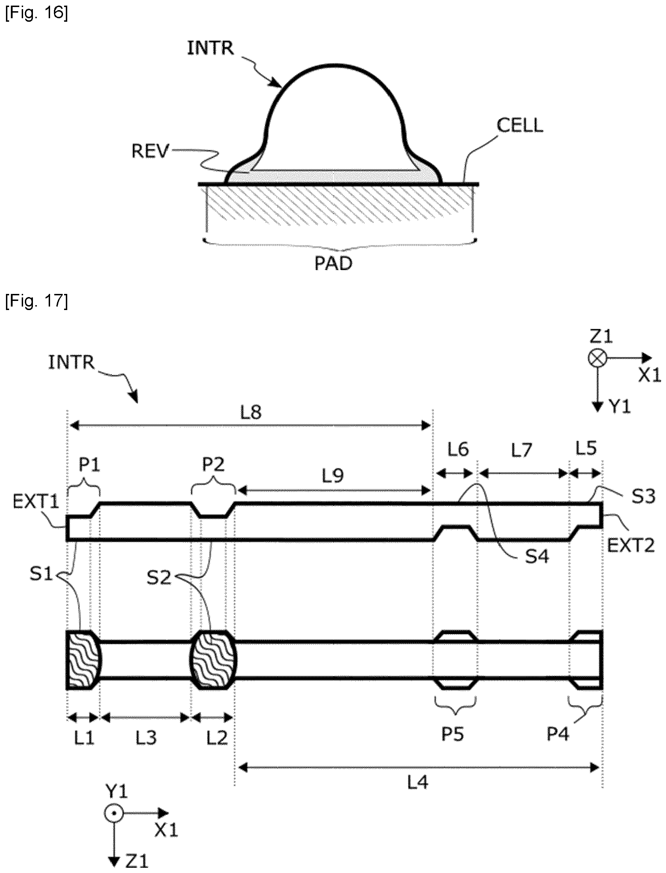

La figure 16 montre le soudage de l'élément INTR de la figure 15 sur une cellule photovoltaïque. Un traitement thermique, appliqué à l'élément INTR, permet de liquéfier l'alliage fusible qui va mouiller la surface de l'élément d'interconnexion INTR et la surface de la cellule photovoltaïque (et plus particulièrement les parties métallisées de cette cellule). Le refroidissement de l'alliage offre une connexion mécanique solide entre ledit élément d'interconnexion INTR et la cellule photovoltaïque.

Le fait que le revêtement en alliage fusible REV puisse être présent avant la mise en forme finale de l'élément d'interconnexion INTR permet de simplifier la fabrication de ce dernier tout en offrant un bon contact mécanique. De plus, la mise en forme (par exemple par écrasement) ne redistribuant pas de manière substantielle le revêtement sur le pourtour de l'élément INTR, la reproductibilité du soudage est conservée.

Les figures 17 à 20 montrent quatre autres modes de réalisation de l'élément d'interconnexion INTR. À la différence des modes de réalisation exposés précédemment (notamment des correspondant aux figures 2, 4, 11 et 13), l'élément d'interconnexion INTR présente au moins des troisième et quatrième surfaces planes S3, S4.

En effet, l'élément d'interconnexion INTR présente des quatrième et cinquième portions P4, P5. Ladite quatrième portion P4 s'étend par exemple sur une longueur L5. Elle peut s'étendre depuis la deuxième extrémité EXT2 (telle qu'illustré dans les figures 17 à 20) ou être distante de la deuxième extrémité EXT2, par exemple d'au moins 0,5 mm. La cinquième portion P5 est distante de la quatrième portion P4 et de la première extrémité EXT1. La cinquième portion P5 s'étend sur une longueur L6. Elle est distance de la quatrième portion P4 d'une longueur L7 et de la première extrémité EXT1 d'une longueur L8.

Les quatrième et cinquième portions P4, P5 présentent respectivement des troisième et quatrième surfaces planes S3, S4. À la différence des première et deuxième surfaces planes S1, S2, les troisième et quatrième surfaces planes S3, S4 sont orientées selon une direction opposée à la deuxième direction Y1 (c'est-à-dire selon la direction -Y1). La troisième surface plane S3 appartient à la quatrième portion P4. La quatrième surface plane S4 appartient à la cinquième portion P5.

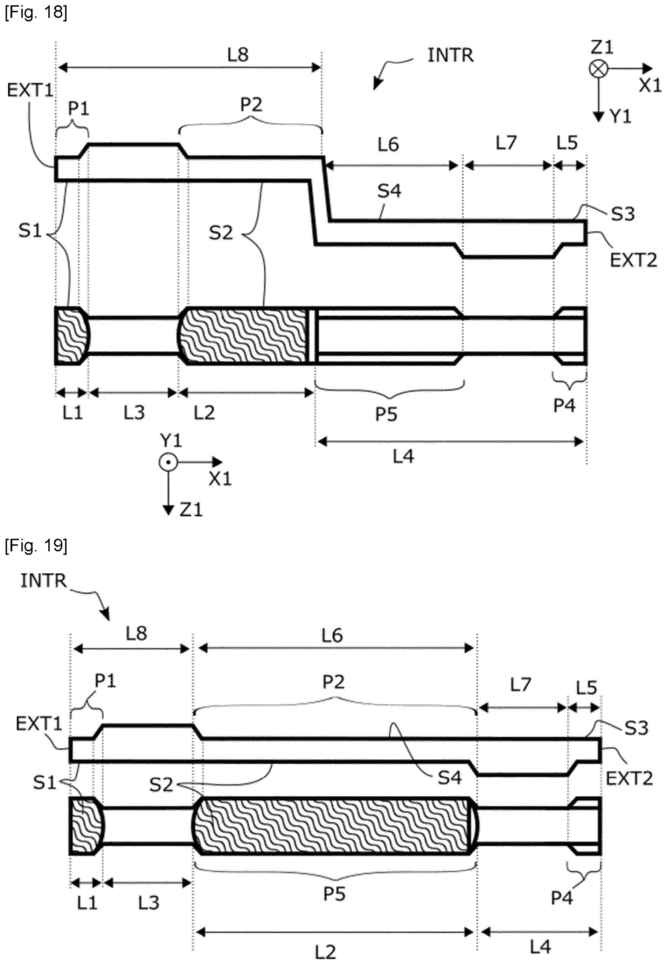

Dans le mode de réalisation de la figure 17, les deuxième et cinquième portions P2, P5 sont distantes l'une de l'autre d'une longueur L9. La longueur L9 est préférentiellement comprise entre 0,5 mm et 2 mm. Dans le mode de réalisation de la figure 18, les deuxième et cinquième portions P2, P5 sont adjacentes. La longueur L9 n'existe donc pas. Dans le mode de réalisation de la figure 19, les deuxième et cinquième portions P2, P5 se confondent au moins partiellement. Une partie au moins de la quatrième surface plane S4 est donc à l'aplomb d'une partie au moins de la deuxième surface plane S2. Selon un développement, la quatrième surface plane S4 est à l'aplomb de la deuxième surface plane S2.

Dans le mode de réalisation de la figure 18, l'élément d'interconnexion change de plan. C'est-à-dire qu'il passe d'un premier plan, parallèle au plan {X1, Y1}, à un deuxième plan, également parallèle au plan {X1, Y1}. L'élément INTR comprend alors un coude de sorte qu'il s'étende, au moins sur une petite distance, selon la direction Z1. Ce coude permet de connecter des cellules photovoltaïques en série, lorsqu'elles sont agencées dans un même plan.

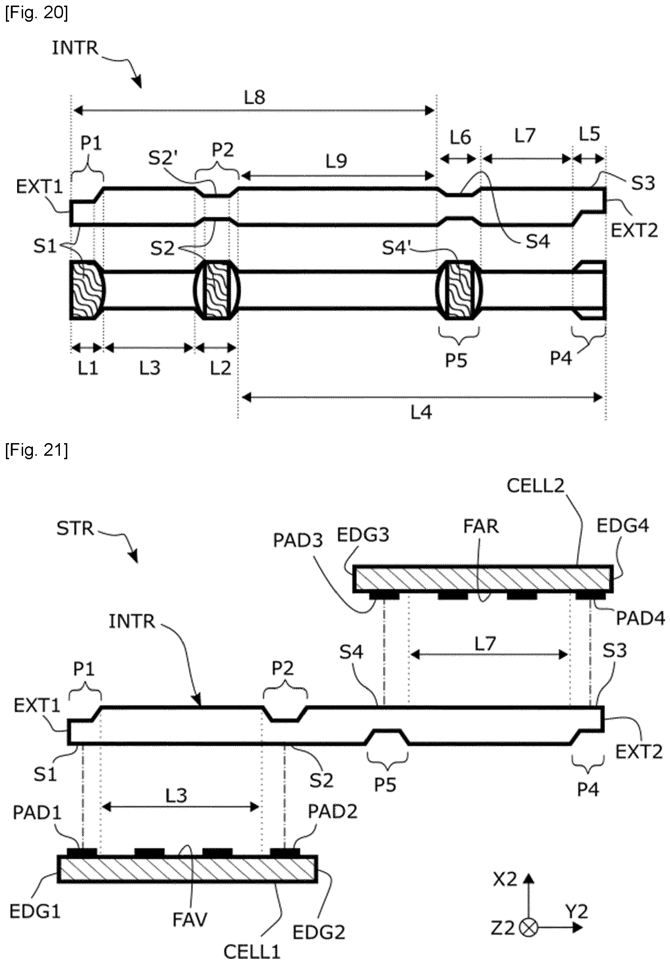

L'élément d'interconnexion INTR de la figure 20 présente également, en complément des quatre surfaces planes S1, S2, S3, S4 exposées précédemment, une deuxième surface plane additionnelle S2' et une quatrième surface plane additionnelle S4'. Les surfaces planes additionnelles S2', S4' appartiennent à, respectivement, la deuxième portion P2 et la cinquième portion P5. La deuxième surface plane additionnelle S2' est opposée à la deuxième surface plane S2 et préférentiellement parallèle à cette dernière. La quatrième surface plane additionnelle S4' est également opposée à la quatrième surface plane S4 et préférentiellement également parallèle à cette dernière.

Les surfaces planes additionnelles S2', S4' peuvent être obtenues par écrasement de l'élément d'interconnexion INTR. En revanche, au lieu d'utiliser un guide (comme illustré dans la figure 5) pour conserver une section comprenant un arc de cercle, une deuxième enclume peut être utilisée.

Réaliser des surfaces planes additionnelles simplifie la mise en forme de l'élément d'interconnexion INTR. En effet, dans les équipements actuels, les fils passent dans des orifices rectangulaires pour être attrapés et tirés sur la longueur de la cellule à connecter. La largeur des orifices est supérieure à celle des fils afin que les fils puissent être alignés facilement avec ces ouvertures. L'écrasement planaire double face peut donc être réalisé au niveau de ces ouvertures, avant d'être attrapés, au moyen de deux enclumes, en regard l'une de l'autre, qui viennent écraser localement le fil.

La forme partiellement cylindrique des première et deuxième portions peut nécessiter que le fil soit inséré dans un guide GD, qui peut présenter une forme de goulotte comprenant une ouverture de la taille du fil. L'alignement est plus complexe à réaliser.

Les première et/ou quatrième portions pourraient également présenter des surfaces planes additionnelles, opposées aux surfaces planes.

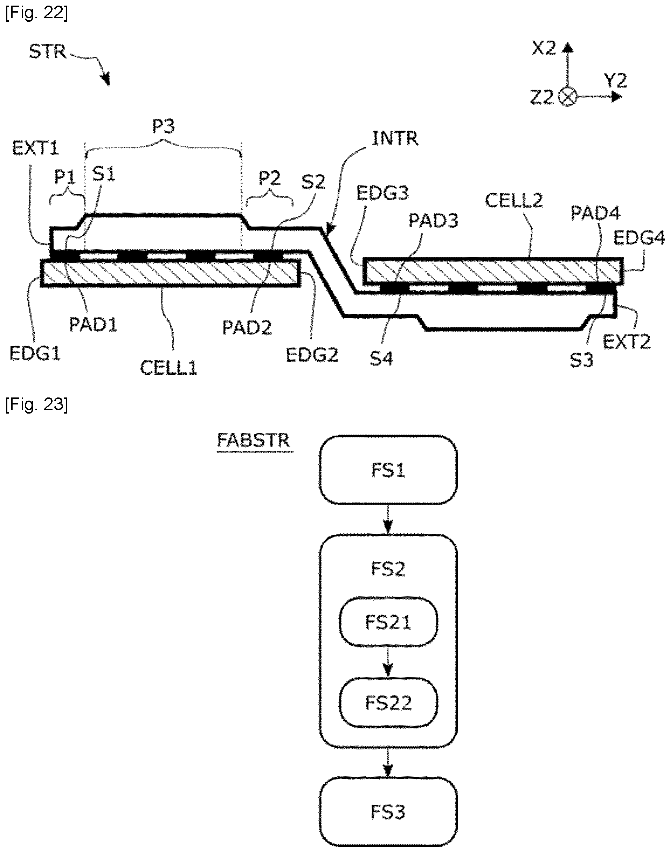

Les figures 21 et 22 montrent deux modes de réalisation d'une chaîne photovoltaïque STR selon l'invention. La chaîne STR comprend au moins deux cellules photovoltaïques CELL1, CELL2, interconnectée en série. La deuxième cellule photovoltaïque CELL2 est connectée électriquement et mécaniquement à la première cellule photovoltaïque CELL1 au moyen d'au moins un élément d'interconnexion INTR tel qu'exposé précédemment et préférentiellement au moyen d'une pluralité d'éléments d'interconnexion INTR tels qu'exposés précédemment. Les figures 21 et 22 montrent une chaîne STR comprenant un seul élément d'interconnexion INTR. Toutefois les enseignements décrits ci-après se transposent également à une chaîne STR comprenant une pluralité d'éléments d'interconnexion INTR. La figure 21 montre un éclaté de la chaîne STR avec un élément INTR. La figure 22 montre la chaîne STR assemblée avec un élément INTR. Les deux cellules photovoltaïques CELL1, CELL2 sont agencées parallèlement à un plan. Dans la figure 22, les cellules CELL1, CELL2 sont agencées dans ce même plan.

De manière commune aux figures 16 et 17, la première cellule photovoltaïque CELL1 comprend des premier et deuxième bords EDG1, EDG2, opposés l'un à l'autre. Elle comprend également une première face FAV, orientée selon une quatrième direction X2, perpendiculaire au plan dans lequel s'étend la première cellule CELL1. La deuxième cellule photovoltaïque CELL2 comprend des troisième et quatrième bords EDG3, EDG4, opposés l'un à l'autre. Le troisième bord EDG3 est préférentiellement parallèle au deuxième bord EDG2 et en vis-à-vis de ce dernier. La deuxième cellule CELL2 comprend également une deuxième face FAR, orientée selon une direction -X2 opposée à la quatrième direction X2. La première face FAV de la première cellule CELL1 peut correspondre à une face avant de ladite cellule CELL1, c'est-à-dire une face destinée à être exposée de manière privilégiée à un rayonnement électromagnétique tel que le rayonnement solaire. La deuxième face FAR de la deuxième cellule CELL2 peut correspondre à une face arrière de ladite cellule CELL2.

Les cellules CELL1, CELL2 peuvent être formée à base de silicium. Il peut s'agir de cellules à homojonction de silicium ou à hétérojonction de silicium. Les cellules CELL1, CELL2 peuvent présenter, sur leurs surfaces, une couche isolante (dans le cas d'une cellule à homojonction) ou une couche d'oxyde conducteur (dans le cas d'une cellule à hétérojonction). Elles peuvent également présenter, sur leurs surfaces, par exemple sur la couche d'oxyde conducteur, des métallisations telles que des plots métalliques, des lignes conductrices ou des électrodes de collecte.

La première face FAV de la première cellule CELL1 comprend une première pluralité de portions destinées à être connectées à l'élément d'interconnexion INTR. La première pluralité de portions à connecter est distribuée entre le premier bord EDG1 et le deuxième bord EDG2 suivant une cinquième direction Y2 perpendiculaire à la quatrième direction X2. La cinquième direction Y2 est avantageusement la direction dans laquelle s'étend la chaîne STR. Les premier et deuxième bords EDG1, EDG2 s'étend avantageusement selon une sixième direction Z2, perpendiculaire aux quatrième et cinquième directions X2, Y2. Chaque portion de la première pluralité de portions à connecter peut présenter une surface libre, telle qu'une portion d'oxyde conducteur uniquement, ou une surface métallisée, telle qu'une ligne conductrice ou un plot métallique, ou une combinaison de ces éléments, c'est-à-dire des plots et/ou une ligne conductrice s'étendant sur un oxyde conducteur.

Un élément d'interconnexion INTR s'étend, selon la quatrième direction X2, en partie sur la première face FAV de la première cellule CELL1 et plus particulièrement sur chacune des portions à connecter de la première pluralité de portions à connecter. L'élément d'interconnexion INTR s'étend au-delà du deuxième bord EDG3 jusqu'à atteindre la deuxième cellule photovoltaïque CELL2 et plus particulièrement la deuxième face FAR de ladite deuxième cellule photovoltaïque CELL2.

L'élément d'interconnexion INTR est avantageusement connecté mécaniquement (et préférentiellement électriquement) à chacune des portions à connecter de la première pluralité de portions à connecter. L'élément d'interconnexion INTR est également avantageusement connecté mécaniquement (et préférentiellement électriquement) à la deuxième face FAR de la deuxième cellule CELL2.

En particulier, la première surface S1 de la première portion P1 dudit élément d'interconnexion INTR est connectée sur une première portion PAD1 à connecter, par exemple la portion la plus proche du premier bord EDG1. La deuxième surface S2 de la deuxième portion P2 dudit élément d'interconnexion INTR est connectée sur une deuxième portion PAD2 à connecter, par exemple la plus proche du deuxième bord EDG2. L'élément d'interconnexion INTR est donc connecté avec une adhésion élevée en au moins deux endroits de la cellule, ce qui permet d'avoir une robustesse élevée. En effet, la force de traction qui s'exerce sur l'élément d'interconnexion INTR est généralement perpendiculaire au plan de la chaîne. Puisque l'élément d'interconnexion INTR selon l'invention, offre des surfaces planes S1, S2 présentant des surfaces de contact grande, la connexion mécanique est améliorée et le risque d'arrachement réduit.

L'élément INTR peut d'ailleurs être connecté au voisinage de chacun des premier et deuxième bords EDG1, EDG2 au moyen des première et deuxième surfaces planes S1, S2. L'arrachement d'un élément d'interconnexion sur une cellule photovoltaïque intervient toujours au niveau d'un bord car, d'une part c'est là que se concentrent les contraintes lors du refroidissement des éléments (cellule et/ou élément d'interconnexion) et d'autre part c'est là que s'exercent les contraintes d'arrachement lors de la manipulation des chaînes.

La troisième portion P3 de l'élément INTR s'étend sur le reste des portions à connecter et est préférentiellement connectée à chacune de ces portions.

Dans le cas où une pluralité d'éléments d'interconnexion INTR interconnectent les première et deuxième cellules CELL1, CELL2 entre elles, chaque élément d'interconnexion INTR s'étend sur une pluralité distincte de portions à connecter et de la façon décrite précédemment. C'est-à-dire, la première surface S1 de chaque élément INTR est connectée sur une des portions à connecter, préférentiellement la plus proche du premier bord EDG1. La deuxième surface S2 de chaque élément INTR est connectée sur une autre des portions à connecter, préférentiellement la plus proche du deuxième bord EDG2.

Les deux portions sur lesquels l'élément d'interconnexion INTR est connecté, et préférentiellement toutes les portions de la première pluralité de portions à connecter, peuvent présenter une surface libre et/ou métallisée. Lorsqu'il s'agit d'une surface libre, la portion peut comprendre une surface d'oxyde transparent conducteur (dit TCO pour « Transparent Conductive Oxide » en anglais). Si ces portions ne permettent pas de réaliser un bon contact électrique, elles peuvent en revanche offrir un bon contact mécanique. En effet, certains adhésifs, par exemple à base d'époxy, montrent une bonne adhérence sur les surfaces non métallisées et en particulier sur les oxydes transparents conducteurs.

Les portions à connecter peuvent comprendre une partie libre et une partie métallisée. La partie métallisée est par exemple une piste métallique telle qu'un busbar ou un plot métallique ou encore une électrode de collecte. Les surfaces métallisées permettent d'établir un contact électrique. Ainsi, l'emploi d'un adhésif électriquement conducteur, comprenant par exemple des particules métalliques dans de l'époxy ou de l'acrylate, permet de réaliser un contact mécanique et électrique avec la partie métallisée et un contact mécanique avec la partie libre.

Une surface métallisée peut présenter un intérêt pour réaliser une connexion par soudure de l'élément d'interconnexion INTR, que ce soit au moyen d'un alliage conducteur d'apport ou grâce à un revêtement d'alliage fusible de l'élément d'interconnexion INTR.

Lorsque l'adhésion de l'élément d'interconnexion INTR sur les portions à connecter est réalisée au moyen d'un adhésif électriquement conducteur, l'épaisseur de ladite pâte adhésive peut être réduite, par exemple inférieure à 70 µm. Une épaisseur inférieure à 40 µm peut également être envisagée. En effet, l'adhésion d'un élément d'interconnexion filaire (c'est-à-dire uniquement cylindrique) nécessite des portions d'adhésif qui soient épaisses, pour pouvoir augmenter la surface en contact avec l'élément filaire. Les surfaces planes S1, S2 de l'élément d'interconnexion INTR ne nécessitent pas, au contraire, de disposer de portions d'adhésif épaisses, pour adhérer sur une surface importante.

La largeur de l'adhésif, mesurée selon la direction Z2, peut également être modulée selon qu'il soit utilisé pour connecter une des surfaces planes S1, S2 ou une partie de la troisième portion P3. L'adhésif présente par exemple une largeur 600 µm et 800 µm pour connecter les surfaces planes S1, S2. Il peut présenter une largeur comprise entre 400 µm et 600 µm pour connecter la troisième portion P3.

La deuxième face FAR de la deuxième cellule CELL2 peut également présenter une deuxième pluralité de portions à connecter. Elles sont distribuées entre le troisième bord EDG3 et le quatrième bord EDG4, préférentiellement suivant la cinquième direction Y2. L'élément d'interconnexion INTR s'étend alors avantageusement sur la deuxième face et sur chaque portion à connecter de la deuxième pluralité de portions à connecter. De manière avantageuse, la troisième surface S3 de la quatrième portion P4 dudit élément d'interconnexion INTR est connectée sur une portion à connecter et préférentiellement la plus proche du quatrième bord EDG4. La quatrième surface S4 de la cinquième portion P5 dudit élément d'interconnexion INTR est avantageusement connectée sur une autre portion à connecter, préférentiellement la plus proche du troisième bord EDG3. De cette manière, la connexion mécanique et/ou électrique sur la deuxième cellule CELL2 est également améliorée.

À la différence de la figure 21, l'élément d'interconnexion INTR de la figure 22 présente un coude entre le deuxième bord EDG2 et le troisième bord EDG3 de manière à changer de plan. Ainsi, les première et deuxième cellules CELL1, CELL2 peuvent être agencées dans un même plan.

La figure 23 illustre schématiquement un mode de mise en oeuvre du procédé de fabrication FABSTR d'une chaîne photovoltaïque STR, telle qu'illustrée dans les figures 21 et 22. Le procédé FABSTR comprend en premier lieu une étape de fourniture FS1 des première et deuxième cellules photovoltaïques CELL1, CELL2 telles que décrites précédemment. Les deux cellules photovoltaïques sont disposées parallèlement à un plan, voire dans un même plan (pour réaliser la chaîne STR de la figure 22).

Le procédé FABSTR comprend également une étape d'interconnexion FS2 de la deuxième cellule CELL2 à la première cellule CELL1, au moyen d'au moins un élément d'interconnexion INTR tel que décrit précédemment. Chaque élément d'interconnexion est connecté sur la première face FAV de la première cellule CELL1 de sorte qu'il s'étende, selon la cinquième direction Y2, sur la première pluralité de portions à connecter et au-delà du deuxième bord EDG2, jusqu'à la deuxième cellule CELL2. La première surface S1 de la première portion P1 de chaque élément d'interconnexion INTR est connectée sur l'une des portions à connecter les plus proches du premier bord EDG1 et la deuxième surface S2 de la deuxième portion P2 de chaque élément d'interconnexion INTR est connectée sur l'une des portions à connecter les plus proches du deuxième bord EDG2.

Avantageusement, lorsque la connexion est réalisée par collage, l'étape d'interconnexion FS2 comprend une étape de dépôt FS21 d'une portion de pâte adhésive conductrice sur chacune des portions à connecter. Elle comprend ensuite une étape de pressage FS22 de la première surface S1 de la première portion P1 de chaque élément d'interconnexion INTR. Le pressage FS22 est avantageusement également réalisé sur la deuxième surface plane S2 de chaque élément d'interconnexion INTR. L'étape de pressage FS22 s'applique également avantageusement de la même manière pour les troisième et quatrième surfaces planes S3, S4 de chaque élément d'interconnexion INTR.

Que la connexion soit réalisée par collage ou soudage, le procédé de fabrication FABSTR comprend préférentiellement, après l'interconnexion FS2, une étape complémentaire de traitement thermique FS3 d'au moins la première cellule photovoltaïque CELL1 et de chaque élément d'interconnexion INTR. Ainsi, lorsque l'interconnexion est réalisée par collage, l'adhésif est réticulé. Lorsque l'interconnexion est réalisée par soudage, l'alliage conducteur (qu'il s'agisse d'un alliage d'apport ou d'un revêtement en alliage fusible entourant l'élément d'interconnexion) fond, mouille les éléments à souder, puis se solidifie au refroidissement donnant une soudure qui relie les éléments métalliques (ou métallisés)_

Pour les deux types d'interconnections : collage et soudure, une pression mécanique est avantageusement exercée au niveau de chacune des premier et deuxième portions P1, P2 de chaque élément d'interconnexion INTR, lors de ladite étape de traitement FS3. La force de pression est appliquée de manière à appuyer les portions contre la cellule photovoltaïque, en l'occurrence, selon la direction opposée à la quatrième direction X2 (autrement dit, opposée à la direction de la première face FAV). De cette manière, les première et deuxièmes surfaces S1, S2 sont maintenues au contact de la première face FAV de la première cellule CELL1 le temps du collage ou du soudage. D'éventuelles irrégularités de l'élément d'interconnexion INTR (tel qu'un désalignement des surface planes S1, S2 avec une génératrice de la troisième portion P3) sont compensée, permettant de coller/souder correctement l'élément INTR sur chaque portion à connecter. La pression exercée est préférentiellement supérieure à 1 N/mm². Il peut être noté que la pression exercée peut former une légère marque d'indentation sur l'élément d'interconnexion INTR lors du traitement thermique. L'indentation est disposée au niveau des première et deuxième portions P1, P2 et est opposées aux première et deuxième surfaces S1, S2.

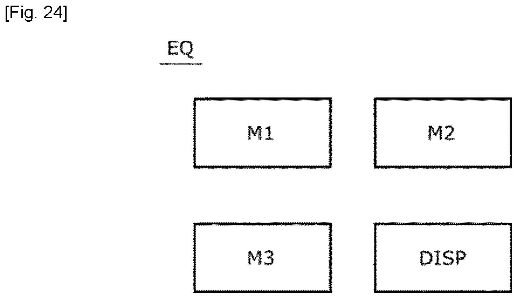

La figure 24 illustre schématiquement un équipement EQ permettant de réaliser la fabrication d'une chaîne photovoltaïque STR telle que décrite précédemment. L'équipement EQ comprend un manipulateur de cellules photovoltaïques M1. Il s'agit par exemple d'un convoyeur ou d'un bras manipulateur muni. Le manipulateur de cellules est notamment configuré pour agencer les cellules CELL1, CELL2 dans un plan, la première face FAV de la première cellule CELL1 étant orienté selon X2.

L'équipement EQ comprend également un manipulateur M2 d'éléments d'interconnexion. Ce manipulateur est configuré pour déposer chaque élément d'interconnexion INTR sur les portions à connecter de la première cellule CELL1. Le manipulateur M2 d'éléments d'interconnexion est particulier en ce qu'il permet d'aligner les éléments d'interconnexion avec les différentes orientations et portions à connecter PAD1, PAD2. Le manipulateur M2 comprend par exemple un système d'alignement, telle qu'une règle optique, pour disposer sur les première et deuxième surfaces planes S1, S2 les première et deuxième portion PAD1, PAD2 à connecter.

L'équipement EQ comprend aussi un moyen de connexion M3 configuré pour connecter l'éléments d'interconnexion INTR aux portions à connecter. Pour cela il peut comprendre un distributeur d'adhésif électriquement conducteur ou de pâte à souder, permettant de placer de l'adhésif ou de la pâte à souder sur les portions à connecter. Le moyen de connexion M3 peut également comprendre un dispositif de traitement thermique, telle qu'un four, une étuve ou une lampe chauffante, permettant de réticuler l'adhésif ou vitrifier la pâte à souder.

L'équipement EQ comprend avantageusement un dispositif DISP de fabrication d'un élément d'interconnexion. De la sorte, chaque élément d'interconnexion INTR peut être mis en forme, à partir d'un fil conducteur cylindrique, juste avant son interconnexion sur la première cellule CELL1.

## Revendications

1. Élément d'interconnexion (INTR) s'étendant selon une première direction (X1), ledit élément d'interconnexion (INTR) **caractérisé en ce qu'**il comporte :
- des première et deuxième extrémités (EXT1, EXT2) opposées ; et
- des première, deuxième et troisième portions (P1, P2, P3) s'étendant entre les première et deuxième extrémités (EXT1, EXT2),
- la première portion (P1) présentant une première surface plane (S1) orientée selon une deuxième direction (Y1) perpendiculaire à la première direction (X1) ;
- la deuxième portion (P2), distante de la première portion (P1) et de la deuxième extrémité (EXT2), la deuxième portion (P2) présentant une deuxième surface plane (S2) orientée selon la deuxième direction (Y1) ;
- la troisième portion (P3), entre la première portion (P1) et la deuxième portion (P2), et présentant une section circulaire (CIRC).

2. Élément d'interconnexion (INTR) selon la revendication 1, **caractérisé en ce que** la première portion (P1) s'étend depuis la première extrémité (EXT1).

3. Élément d'interconnexion (INTR) selon la revendication 1, **caractérisé en ce que** la première portion (P1) est distante de la première extrémité (EXT1).

4. Élément d'interconnexion (INTR) selon l'une des revendications précédentes, **caractérisé en ce qu'**une section de la première portion (P1) comprend un arc de cercle (ARC), au moins un segment de droite (SEG, SEG', SEG") et deux segments de courbe (EPA1, EPA2), ledit au moins un segment de droite (SEG) étant parallèle à une troisième direction (Z1) perpendiculaire aux première et deuxième directions (X1, Y1), les deux segments de courbes (EPA1, EPA2) joignant l'arc de cercle (ARC) et ledit au moins un segment de droite (SEG), l'aire de ladite section de la première portion (P1) étant égale à l'aire de la section de la troisième portion (P3).

5. Élément d'interconnexion (INTR) selon l'une des revendications précédentes, **caractérisé en ce que** les première et deuxième surfaces planes (S1, S2) sont tangentes à la troisième portion (P3).

6. Élément d'interconnexion (INTR) selon l'une des revendications précédentes, **caractérisé en ce que** la section circulaire (CIRC) de la troisième portion (P3) présente un diamètre D, la première surface plane (S1) présentant une première largeur (W1) mesurée selon une troisième direction (Z1) perpendiculaire aux première et deuxième directions (X1, Y1), ladite première largeur (W1) étant supérieure à 0,6×D.

7. Élément d'interconnexion (INTR) selon l'une des revendications précédentes, **caractérisé en ce que** la première portion (P1) présente une première longueur (L1), mesurée selon la première direction (X1), comprise entre 4 mm et 16 mm, et de préférence entre 6 mm et 10 mm.

8. Élément d'interconnexion (INTR) selon l'une des revendications précédentes, **caractérisé en ce qu'**il comprend également :
- des quatrième, cinquième et sixième portions (P4, P5, P6) s'étendant entre les première et deuxième extrémités (EXT1, EXT2),
- la quatrième portion (P4) présentant une troisième surface plane (S3), orientée selon une direction (-Y1) opposée à la deuxième direction (Y1) ;
- la cinquième portion (P5), distante de la quatrième portion (P4) et de la première extrémité (EXT1), la cinquième portion (P5) présentant une quatrième surface plane (S4) orientée selon la direction (-Y1) opposée à la deuxième direction (Y1) ; et
- la sixième portion (P6), entre la quatrième portion (P4) de la cinquième portion (P5) et présentant une section circulaire

9. Élément d'interconnexion (INTR) selon la revendication 8, **caractérisé en ce que** la quatrième portion (P4) s'étend depuis la deuxième extrémité (EXT2).

10. Élément d'interconnexion (INTR) selon la revendication 8, **caractérisé en ce que** la quatrième portion (P4) est distante de la deuxième extrémité (EXT2).

11. Élément d'interconnexion (INTR) selon l'une des revendications 8 à 10, **caractérisé en ce que** la deuxième portion (P2) et la quatrième portion (P4) se confondent au moins partiellement.

12. Élément d'interconnexion (INTR) selon l'une des revendications 8 à 10, **caractérisé en ce que** la deuxième portion (P2) et la cinquième portion (P5) sont distantes l'une de l'autre.

13. Chaîne photovoltaïque (STR) comprenant des première et deuxième cellules photovoltaïques (CELL1, CELL2), la deuxième cellule photovoltaïque (CELL2) étant connectée électriquement à la première cellule photovoltaïque (CELL1), les deux cellules photovoltaïques (CELL1, CELL2) étant parallèles à un plan, la première cellule photovoltaïque (CELL1) comprenant :
- des premier et deuxième bords (EDG1, EDG2) opposés ;
- une première face (FAV), orientée selon une quatrième direction (X2) perpendiculaire audit plan, ladite première face (FAV) comprenant une première pluralité de portions destinées à être connectées à un élément d'interconnexion, la première pluralité de portions à connecter étant distribuée entre le premier bord (EDG1) et le deuxième bord (EDG2) suivant une cinquième direction (Y2) perpendiculaire à la quatrième direction (X2) ;
la chaîne photovoltaïque (STR) est **caractérisée en ce qu'**elle comprend au moins un élément d'interconnexion (INTR) selon l'une des revendications précédentes, s'étendant en partie sur la première face (FAV) et sur la première pluralité de portions à connecter, ledit au moins un élément d'interconnexion (INTR) s'étendant, selon la cinquième direction (Y2), au-delà du deuxième bord (EDG2) de manière à atteindre la deuxième cellule photovoltaïque (CELL2), la première surface (S1) de la première portion (P1) dudit au moins un élément d'interconnexion (INTR) étant connectée sur une première portion à connecter (PAD1) de la première pluralité de portions à connecter, la deuxième surface (S2) de la deuxième portion (P2) dudit au moins un élément d'interconnexion (INTR) étant connectée sur une deuxième portion à connecter (PAD2) de la première pluralité de portions à connecter.

14. Chaîne photovoltaïque (STR) selon la revendication précédente, **caractérisée en ce que** la première portion à connecter (PAD1) est la portion de la première pluralité de portions à connecter la plus proche du premier bord (EDG1) et **en ce que** la deuxième portion à connecter (PAD2) est la portion de la première pluralité de portions à connecter la plus proche du deuxième bord (EDG2).

15. Chaîne photovoltaïque (STR) selon l'une des revendications 13 à 14, **caractérisée en ce qu'**elle comprend également de la pâte adhésive conductrice adhérant à chacune des première et deuxième portions (PAD1, PAD2) de la première pluralité de portions à connecter et audit au moins un élément d'interconnexion (INTR), l'épaisseur de ladite pâte adhésive conductrice étant inférieure à 70 µm.

16. Chaîne photovoltaïque (STR) selon la revendication 13 à 14, **caractérisée en ce qu'**elle comprend également un alliage conducteur soudé à chacune des première et deuxième portions (PAD1, PAD2) de la première pluralité de portions à connecter et audit au moins un élément d'interconnexion (INTR).

17. Chaîne photovoltaïque (STR) selon l'une des revendications 13 à 15 comprenant au moins un élément d'interconnexion (INTR) selon l'une des revendications 8 à 12, **caractérisée en ce que** la deuxième cellule photovoltaïque (CELL2) comprend :
- des troisième et quatrième bords (EDG3, EDG4) opposés, le troisième bord (EDG3) étant parallèle et en vis-à-vis du deuxième bord (EDG2) de la première cellule photovoltaïque (CELL1);
- une deuxième face (FAR), orientée selon une direction (-X2) opposée à la quatrième direction (X2), ladite deuxième face (FAR) comprenant une deuxième pluralité de portions à connecter, distribuées entre le troisième bord (EDG3) et le quatrième bord (EDG4) suivant la cinquième direction (Y2) ;
ledit au moins un élément d'interconnexion (INTR) s'étendant selon la cinquième direction (Y2) sur la deuxième face (FAR) et sur la deuxième pluralité de portions à connecter, la troisième surface (S3) de la quatrième portion (P4) dudit au moins un élément d'interconnexion (INTR) étant connectée sur une quatrième portion (PAD4) à connecter de la deuxième pluralité de portions à connecter, la quatrième surface (S4) de la cinquième portion (P5) dudit au moins un élément d'interconnexion (INTR) étant connectée sur une troisième portion (PAD3) à connecter de la deuxième pluralité de portions à connecter.

18. Procédé de fabrication (FABINTR) d'un élément d'interconnexion comprenant les étapes suivantes :
- fournir (FI1) un fil conducteur, s'étendant selon une première direction (X1), présentant une section circulaire sur toute sa longueur ;
- former (FI2), au niveau d'une première portion (P1) dudit fil conducteur (FIL), une première surface plane (S1) orientée selon une deuxième direction (Y1) perpendiculaire à la première direction (X1) ;
- former (FI3), au niveau d'une deuxième portion (P2), distante de la première portion (P1), une deuxième surface plane (S2) orientée selon la deuxième direction (Y1), une troisième portion (P3), disposée entre les première et deuxième portions (P1, P2) présentant une section circulaire et ;
- couper le fil conducteur (FIL) de manière à former des première et deuxième extrémités (EXT1, EXT2) opposées, les première, deuxième et troisième portions (P1, P2, P3) s'étendant entre les première et deuxième extrémités (EXT1, EXT2), la deuxième portions (P2) étant distante de la deuxième extrémité (EXT2) dudit fil conducteur.

19. Procédé de fabrication (FABINTR) d'un élément d'interconnexion selon la revendication précédente, dans lequel le fil conducteur comprend, avant les étapes de formation (FI2, FI3) des première et deuxième surfaces planes (S1, S2), un revêtement d'alliage fusible (REV).

20. Procédé de fabrication (FABINTR) d'un élément d'interconnexion selon la revendication précédente, dans lequel les première et/ou deuxième surfaces planes sont formées par écrasement du fil conducteur au niveau des, respectivement, première et/ou deuxième portions.

21. Dispositif de fabrication d'un élément d'interconnexion comprenant des moyens adaptés pour réaliser les étapes du procédé de fabrication d'un élément d'interconnexion selon l'une des trois revendications précédentes.

22. Procédé de fabrication (FABSTR) d'une chaîne photovoltaïque comprenant les étapes suivantes :
- fournir (FS1) des première et deuxième cellules photovoltaïques (CELL1, CELL2), les deux cellules photovoltaïques (CELL1, CELL2) étant agencées dans un plan, la première cellule photovoltaïque (CELL1) comprenant :
- des premier et deuxième bords (EDG1, EDG2) opposés ;
- une première face (FAV), orientée selon une quatrième direction (X2), perpendiculaire audit plan, ladite première face (FAV) comprenant une première pluralité de portions destinées à être connectées à un élément d'interconnexion, la première pluralité de portions à connecter étant distribuée entre le premier bord (EDG1) et le deuxième bord (EDG2) suivant une cinquième direction (Y2) perpendiculaire à la quatrième direction (X2) ;
- interconnecter (FS2) la deuxième cellule photovoltaïque (CELL2) à la première cellule photovoltaïque (CELL1) au moyen d'au moins un élément d'interconnexion (INTR) selon l'une des revendications 1 à 12, ledit au moins un élément d'interconnexion (INTR) étant déposé sur la première face (FAV) de la première cellule photovoltaïque (CELL1) de sorte qu'il s'étende en partie sur ladite première face (FAV) et sur la première pluralité de portions à connecter, et de sorte qu'il s'étende, selon la cinquième direction (Y2), au-delà du deuxième bord (EDG2) jusqu'à atteindre la deuxième cellule photovoltaïques (CELL2), la première surface (S1) de la première portion (P1) dudit au moins un élément d'interconnexion (INTR) étant connectée sur une première portion (PAD1) à connecter de la première pluralité de portions à connecter et la deuxième surface (S2) de la deuxième portion (P2) dudit au moins un élément d'interconnexion (INTR) étant connectée sur une deuxième portion (PAD2) à connecter de la première pluralité de portions à connecter.

23. Équipement (EQ) de fabrication d'une chaîne photovoltaïque (STR) comprenant :
- un manipulateur de cellules photovoltaïques (M1) configuré pour agencer des première et deuxième cellules photovoltaïques (CELL1, CELL2) dans un plan et orienter une première face (FAV) de la première cellule photovoltaïque (CELL1) selon une quatrième direction (X2), perpendiculaire audit plan ;
- un manipulateur (M2) d'éléments d'interconnexion comprenant un moyen d'alignement, configuré pour déposer au moins un élément d'interconnexion sur la première face (FAV) de la première cellule photovoltaïque (CELL1) de sorte qu'il s'étende en partie sur ladite première face (FAV) et sur une première pluralité de portions à connecter de la première face (FAV), ladite première pluralité de portions à connecter étant distribuée entre un premier bord (EDG1) de la première cellule (CELL1) et le deuxième bord (EDG2) de la première cellule (CELL1) suivant une cinquième direction (Y2) perpendiculaire à la quatrième direction (X2), les premier et deuxième bords (EDG1, EDG2) de la première cellule (CELL1) étant opposés, et de sorte qu'il s'étende selon la cinquième direction (Y2), au-delà du deuxième bord (EDG2), jusqu'à atteindre la deuxième cellule photovoltaïques (CELL2), la première surface (S1) de la première portion (P1) dudit au moins un élément d'interconnexion (INTR) étant disposée sur une première portion (PAD1) à connecter de la première pluralité de portions à connecter et la deuxième surface (S2) de la deuxième portion (P2) dudit au moins un élément d'interconnexion (INTR) étant disposée sur une deuxième portion (PAD2) à connecter de la première pluralité de portions à connecter ; et
- un moyen de connexion (M3) configuré pour connecter la première surface (S1) de la première portion (P1) dudit au moins un élément d'interconnexion (INTR) sur la première portion (PAD1) à connecter de la première pluralité de portions à connecter ; et connecter la deuxième surface (S2) de la deuxième portion (P2) dudit au moins un élément d'interconnexion (INTR) sur la deuxième portion (PAD2) à connecter de la première pluralité de portions à connecter.

24. Équipement (EQ) selon la revendication précédente comprenant également un dispositif (DISP) de fabrication d'un élément d'interconnexion selon la revendication 21.
